(19) Europäisches Patentamt
European Patent Office
Office européen des brevets

(11) EP 2 157 624 A1

(12) EUROPEAN PATENT APPLICATION

(43) Date of publication:
**24.02.2010 Bulletin 2010/08**

(21) Application number: **09158633.9**

(22) Date of filing: **23.04.2009**

(51) Int Cl.:
***H01L 33/52*** *(2010.01)* ***H01L 23/29*** *(2006.01)*
***C08G 77/04*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **31.07.2008 KR 20080074862**

(71) Applicant: **Korea Advanced Institute of Science and Technology**
**Yuseong-Gu, Daejeon 305-701 (KR)**

(72) Inventors:
- **Bae, Byeong-Soo**
  **Daejeon 305-701 (KR)**
- **Yang, Seung-Cheol**
  **305-701, Daejeon (KR)**

(74) Representative: **Ehnis, Tobias et al**
**Patentanwälte**
**Dr. Gassner & Partner**
**Marie-Curie-Strasse 1**
**91052 Erlangen (DE)**

# (54) Resin composition for led encapsulation

(57) Disclosed is a resin composition for LED encapsulation including an organic oligosiloxane hybrid prepared by non-hydrolytic condensation of organoalkoxysilane. More particularly, the resin composition for LED encapsulation includes an organic oligosiloxane hybrid prepared by non-hydrolytic condensation of organoalkoxysilane with organosilanediol or non-hydrolytic condensation of a mixture containing organoalkoxysilane and metal alkoxide with organosilanediol. The prepared organic oligosilane hybrid has an inorganic network structure with a high degree of condensation and contains at least one organic group or organic functional group. In addition, an encapsulated LED fabricated using the above resin composition for LED encapsulation is provided.

EP 2 157 624 A1

**Description**

BACKGROUND OF THE INVENTION

This application claims priority to Korean Patent Application No. 10-2008-0074862, filed on July 31, 2008, in the Korean Intellectual Property Office, the entire contents of which are hereby incorporated by reference.

1. Field of the Invention

The present invention relates to a resin composition for LED encapsulation, which contains an organic oligosiloxane hybrid prepared by non-hydrolytic condensation of organoalkoxysilane. The resin composition for LED encapsulation has excellent performance for encapsulation of high efficiency LEDs emitting in the blue and/or UV ranges of electromagnetic spectrum and white light emitting devices.

2. Description of the Related Art

It is well known that an LED has an extended lifespan, is driven at a low voltage and exhibits high luminescence efficiency. Such LED also substantially generates no heat and has superior characteristics capable of being used as a heavy metal-free replacement of typical light sources over other light emitting devices. Accordingly, LEDs are increasingly used in various applications including, for example, general lightings, display device, backlights of liquid displays, and the like.

Especially, an LED is an important element in advanced lighting technologies and requires a high luminescence of more than 80 lm/W in order to be used for general lightings and special lightings. As for development of such high efficiency LEDs, a design for adequate heat discharge, an excellent optical design and/or maximum light extraction efficiency are required. In addition, high efficiency/high reliability phosphors are demanded. Moreover, an encapsulation material capable of encapsulating LED (refer to as LED encapsulation material) must have improved reliability. The LED encapsulation material for protecting compound semiconductor chips and electrodes provided in the LED is a very important substance in manufacture of LEDs for enhancing light extraction efficiency.

In general, if LED equipment does not emit light in UV or blue light ranges, aromatic epoxy resin such as bisphenol A epoxy resin is typically used as an encapsulation material in consideration of adhesiveness, heat resistance and/or light resistance. For example, Japanese Patent Laid-Open No. 2003-002951A discloses a process for encapsulation of photonic semiconductors such as LEDs using aromatic epoxy resin. However, in case of the LED emitting in UV or blue light ranges, which is directed to fulfilling of high efficiencies, the aromatic epoxy resin is susceptible to yellowing due to UV exposure or degradation. Korean Patent Laid-Open No. 10-2008-0043381 describes epoxy resin suitable to LED encapsulation material. The epoxy resin uses acid anhydride as a curing agent to reduce yellowing of aromatic epoxy resin and also uses alicyclic epoxy resin to reduce discoloration and to make the epoxy resin transparent. The non-yellowing epoxy resin in an anhydride form is used as a hardening agent and the alicyclic epoxy resin allows production of transparent epoxy resin while reducing changes in color.

A silicon based polymer compound with excellent light transmittance as well as light resistance has been proposed as a resin suitable for LED encapsulation for quite a long period of time. For example, Japanese Patent Laid-Open No. 2004-359756A describes an LED encapsulation composition. In case the LED encapsulation composition is cured, it contains at least one polyorganosiloxane and has at least one functional group selected from a group consisting of organic functional group, hydroxyl group and hydrogen atom, as well as a hydrocarbon group having at least one multiple bond and a hydrogen atom. Also, Japanese Patent Laid-Open No. 2004-186168A describes a silicon resin composition for LEDs. Such silicon resin composition essentially contains a silicon resin having an alkenyl group bonded to at least two silicon atoms in one molecule, an organic hydrogen silane or organic hydrogen polysiloxane having a hydrogen atom bonded to at least two silicon atoms, and a catalyst for addition reaction.

However, any existing silicon polymer compound for LED is known to have less adhesiveness and a low refractive index of about 1.4, thus entailing degradation in luminescence efficiency. Accordingly, in order to improve the luminescence efficiency of LED, it still requires development of novel materials with improved adhesiveness, light resistance and/or heat resistance in addition to a high refractive index of about 1.5.

SUMMARY OF THE INVENTION

Accordingly, it is an object of the present invention to provide a resin composition useful in production of resin for LED encapsulation with excellent light transmittance, light resistance, heat resistance, mechanical strength and high refractive index and, in addition, little shrinkage occurring in a molding process. In order to prepare the resin composition for LED encapsulation, the present invention uses an organic oligosiloxane hybrid in a compact inorganic network

structure having organic groups and/or organic functional groups.

In order to achieve the above object of the present invention, there is provided a resin composition for LED encapsulation containing an organic oligosiloxane hybrid, wherein the hybrid is prepared by non-hydrolytic condensation of organoalkoxysilane with organosilanediol, or by non-hydrolytic condensation of a mixture including organoalkoxysilane and metal alkoxide with organosilanediol.

The resin composition for LED encapsulation containing an organic oligosiloxane hybrid according to the present invention substantially includes a homogeneous combination of inorganic ingredients and organic ingredients in terms of molecules thereof. Therefore, the resin composition for LED encapsulation exhibits considerably excellent stability, mechanical properties, heat resistance and light resistance, and has improved light transmittance and high refractive index. In addition, the inventive resin composition may supply some organic groups and/or organic functional groups to the organic oligosiloxane hybrid, thereby controlling different physical properties such as a refractive index.

DETAILED DESCRIPTION OF THE INVENTION

An organic oligosiloxane hybrid according to the present invention is prepared by non-hydrolytic condensation of organoalkoxysilane with organosilanediol, or non-hydrolytic condensation of a mixture containing organoalkoxysilane and metal alkoxide with organosilanediol.

The resulting organic oligosiloxane hybrid has a high degree of condensation, excellent light resistance, heat resistance, light transmittance, mechanical properties, high refractive index and substantially little shrinkage occurring in a molding process.

An organic oligosiloxane hybrid refers to a compound in which inorganic ingredients are combined with organic ingredients or organic functional groups in molecular units and is typically prepared by non-hydrolytic condensation of organoalkoxysilane.

Hereinafter, the present invention will be described in more details.

The organic oligosiloxane hybrid contained in LED encapsulation resin according to the present invention is obtained by sol-gel reaction. More particularly, the inventive organic oligosiloxane hybrid may be prepared by non-hydrolytic condensation of organoalkoxysilane with organosilanediol or by non-hydrolytic condensation of a mixture containing organoalkoxysilane and metal alkoxide with organosilanediol. Such non-hydrolytic condensation is a sol-gel reaction without addition of water shown in the following reaction scheme. In view of not using water, the non-hydrolytic condensation is different from conventional hydrolytic sol-gel reactions.

Owing to a difference in reaction kinetics between two different materials, a hydrolytic sol-gel reaction thereof has difficulty in formation of a complex oxide, leading to a limitation in selecting desired precursors. The hydrolytic sol-gel reaction normally using water entails problems such as a requirement for high temperature heat treatment, degradation in stabilities of reactive materials due to un-reacted hydroxyl groups contained therein, and so on.

On the other hand, the non-hydrolytic sol-gel reaction in the present invention may overcome problems of the hydrolytic sol-gel reaction described above and, in addition, may use complex oxides and/or various precursors so as to produce organic oligosiloxane nano-hybrids.

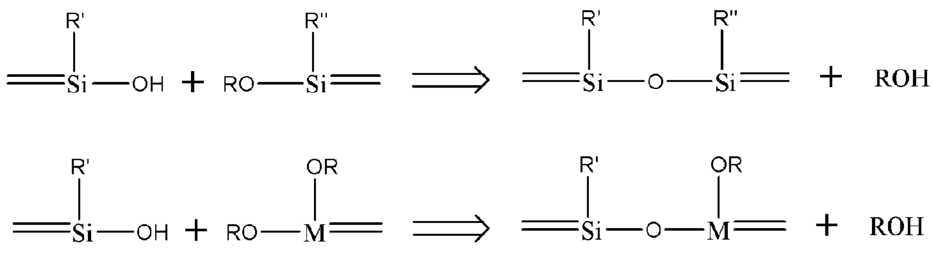

M = Metal

Such organic oligosiloxane nano-hybrid is produced by condensation according to the above reaction scheme. A hydroxyl group of organosilanediol as a starting material and alkoxy group of organoalkoxysilane in a monomer form undergo condensation to form an inorganic network structure.

Otherwise, a hydroxyl group of the starting material, that is, organosilanediol reacts with an alkoxy group of a mixture containing organoalkoxysilane and metal alkoxide in a monomer form by condensation, so as to form an inorganic network structure. The organic oligosiloxane hybrid having modified organic groups R' and R" is formed around the compound having the inorganic network structure.

In order to prepare the organic oligosiloxane hybrid, since a non-hydrolytic sol-gel reaction is carried out at a low temperature, a desired catalyst may be added thereto in order to accelerate the reaction even at the low temperature.

Such catalyst may comprise metal hydroxides such as barium hydroxide, strontium hydroxide, etc. An amount of the catalyst to be introduced is not particularly limited but preferably ranges from 0.0001 to 10 mol% to monomer used in the reaction. The reaction may be performed at room temperature under agitation for 6 to 72 hours. In order to increase a reaction rate and completely perform the condensation, the reaction may be performed at a temperature ranging from 0 to 100°C, preferably 40 to 80°C, for 1 to 10 hours.

Alcohol as a byproduct is often presented in the organic oligosiloxane hybrid prepared by condensation. In order to remove the alcohol of the byproduct, the prepared hybrid may be heated to 0 to 120°C under atmosphere and/or vacuum. More preferably, the heating is performed at 40 to 80°C under a pressure of about -0.1MPa for 10 minutes to 1 hour.

The organoalkoxysilane may include at least one selected from compounds represented by Formula 1 or a mixture of two or more thereof. The organoalkoxysilane contains at least one alkoxy group and an organic chain substituted or not substituted by a functional group:

Formula 1

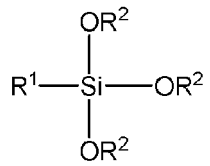

wherein $R^1$ is at least one selected from a group consisting of $C_1$ to $C_{20}$ alkyl, $C_3$ to $C_8$ cycloalkyl, $C_1$ to $C_{20}$ alkyl substituted by $C_3$ to $C_8$ cycloalkyl, $C_2$ to $C_{20}$ alkenyl, $C_2$ to $C_{20}$ alkynyl and $C_6$ to $C_{20}$ aryl and each of which may have at least one functional group selected from a group consisting of acryl, methacryl, allyl, halogen, amino, mercapto, ether, ester, $C_1$ to $C_{20}$ alkoxy, sulfone, nitro, hydroxyl, cyclobutene, carbonyl, carboxyl, alkyd, urethane, vinyl, nitrile and epoxy groups; and $R^2$ is a linear or branched $C_1$ to $C_7$ alkyl group.

More particularly, the organoalkoxysilane may include at least one selected from a group consisting of 3-glycidoxypropyl trimethoxysilane, 3-glycidoxypropyl triethoxysilane, 2-(3,4-epoxycyclohexyl)ethyl trimethoxysilane, 2-(3,4-epoxycyclohexyl)ethyl triethoxylsilane, methyltrimethoxysilane, methyltriethoxysilane, methyltripropoxysilane, propylethyltrimethoxysilane, ethyltriethoxysilane, vinyltrimethoxysilane, vinyltriethoxysilane, vinyltripropoxysilane, phenyltrimethoxysilane, N-(3-acryloxy-2-hydroxypropyl)-3-aminopropyl triethoxysilane, N-(3-acryloxy-2-hydroxypropyl)-3-aminopropyl trimethoxysilane, N-(3-acryloxy-2-hydroxypropyl)-3-aminopropyl tripropoxysilane, 3-acryloxypropyl methylbis(trimethoxy)silane, 3-acryloxypropyl trimethoxysilane, 3-acryloxypropyl triethoxysilane, 3-acryloxypropyl tripropoxysilane, 3-(meth)acryloxypropyl trimethoxysilane, 3-(meth)acryloxypropyl triethoxysilane, 3-(meth)acryloxypropyl tripropoxysilane, N-(aminoethyl-3-aminopropyl)trimethoxysilane, N-(2-aminoethyl-3-aminopropyl)triethoxysilane, 3-aminopropyl trimethoxysilane, 3-aminopropyl triethoxysilane, chloropropyl trimethoxysilane, chloropropyl triethoxysilane and heptadecafluorodecyl trimethoxysilane or a mixture of two or more thereof, however, the present invention is not particularly limited thereto.

The organosilanediol may include at least one selected from compounds represented by Formula 2 or a mixture of two or more thereof. The organosilanediol contains two hydroxyl groups and an organic chain substituted or not substituted by a functional group:

Formula 2

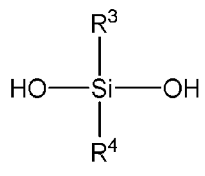

wherein $R^3$ and $R^4$ are independently at least one selected from a group consisting of $C_1$ to $C_{20}$ alkyl, $C_3$ to $C_8$ cycloalkyl,

$C_1$ to $C_{20}$ alkyl substituted by $C_3$ to $C_8$ cycloalkyl, $C_2$ to $C_{20}$ alkenyl, $C_2$ to $C_{20}$ alkynyl and $C_6$ to $C_{20}$ aryl and each of which may have at least one functional group selected from a group consisting of acryl, methacryl, allyl, halogen, amino, mercapto, ether, ester, $C_1$ to $C_{20}$ alkoxy, sulfone, nitro, hydroxyl, cyclobutene, carbonyl, carboxyl, alkyd, urethane, vinyl, nitrile and epoxy groups.

More particularly, the organosilanediol may include at least one selected from a group consisting of diphenylsilanediol and diisobutylsilanediol or a mixture of two or more thereof, however, the present invention is not particularly limited thereto.

The metal alkoxide may include at least one selected from compounds represented by Formula 3 or a mixture of two or more thereof. The metal alkoxide is a metal compound having at least one alkoxy group bonded thereto.

Formula 3 $M\text{-}(OR^5)_n$

wherein M is at least one selected from a group consisting of aluminum, germanium, titanium, zirconium and tantalum; n is atomic valence of M; and $R^5$ is a linear or branched $C_1$ to $C_7$ alkyl group.

Such n ranges from 1 to 5, preferably 3 to 5. M is a metal substance having an atomic valence in the range of 3 to 5, which may be exemplified by aluminum, germanium, titanium, zirconium and tantalum.

More particularly, the metal alkoxide may include at least one selected from a group consisting of aluminum ethoxide, tantalum ethoxide, germanium ethoxide, titanium ethoxide, zirconium ethoxide, zirconium propoxide, titanium propoxide, aluminum isopropoxide, germanium isopropoxide, titanium isopropoxide, zirconium isopropoxide, aluminum tributoxide, tantalum butoxide, aluminum t-butoxide, titanium butoxide, titanium t-butoxide, zirconium butoxide and zirconium t-butoxide or a mixture of two or more thereof, however, the present invention is not particularly limited thereto.

According to the present invention, when the organic oligosiloxane hybrid is prepared by non-hydrolytic condensation of a mixture containing organoalkoxysilane and metal alkoxide with organosilanediol, a content of metal alkoxide preferably may range from 1 to 80 mol% relative to 100 mol% of the mixture. The content of metal alkoxide preferably ranges from 20 to 70 mol% relative to 100 mol% of the mixture. In this case, the organic oligosiloxane hybrid may have a high refractive index as well as a high degree of condensation. When the content of metal alkoxide is excessively high, a transmittance of the hybrid tends to decrease whereas increasing the refractive index. In contrast, if the content of metal alkoxide is too small, a high refractive index is difficult to achieve.

Compared to organoalkoxysilane, metal alkoxide exhibits the faster reaction rate in reacting with organosilanediol. Therefore, in order to uniformly prepare a resin composition for LED encapsulation, which contains an organic oligosiloxane hybrid, the reaction rate of metal alkoxide must be controlled to a level substantially identical to that of organoalkoxysilane. To control the reaction rate of metal alkoxide, a metal chelating agent is preferably added thereto. Such a metal chelating agent may include a β-diketonate compound such as acetylacetone or an organic acid having an unsaturated hydrocarbon group such as acrylic acid, methacrylic acid, etc. Adding the metal chelating agent may allow a metallic chelate to substitute an alkoxy group of metal alkoxide to form a metal chelate-metal alkoxide complex. Here, in order to substitute only a part of alkoxy group in the metal alkoxide by the metal chelate, an amount of the added metal chelating agent may be regulated. More particularly, the metal chelating agent is preferably added in an amount of 1/5 to 1/2 equivalent weight to alkoxy group of the metal alkoxide. Addition of the metal chelating agent in such equivalent weight allows a reaction rate of metal alkoxide to reach near that of organoalkoxysilane, so that metal ingredients may be homogeneously dispersed in an inorganic network structure.

When a solvent is added to the organic oligosiloxane hybrid according to the present invention, the organic oligosiloxane hybrid-containing resin for LED encapsulation may have improved stability as well as controlled viscosity.

Such solvent should be added in a desired amount not affecting functional effects of the present invention. Also, the solvent may be optionally added during a process of preparing the organic oligosiloxane hybrid or after completion thereof. Examples of the solvent may include at least one selected from a group consisting of: an aliphatic hydrocarbon solvent such as hexane, heptane, etc.; a ketone solvent such as methylisobutylketone, 1-methyl-2-pyrrolidinone, cyclohexanone, acetone, etc.; an ether solvent such as tetrahydrofuran, isopropylether, propyleneglycol propylether, etc.; an acetate solvent such as ethyl acetate, butyl acetate, propyleneglycol methylether acetate, etc.; an alcohol solvent such as isopropylalcohol, butylalcohol, etc.; an amide solvent such as dimethylacetamide, dimethylformamide, etc.; and a silicon solvent, however, the present invention is not particularly limited thereto.

The organic oligosiloxane hybrid of the present invention may further include a thermocurable functional group or photocurable functional group. In this regard, the organic oligosiloxane hybrid is prepared through a thermocuring or photocuring process, so as to fabricate a compact LED capsule. As a result, the oligosiloxane hybrid-containing resin for LED encapsulation may have excellent mechanical properties and thermal characteristics, thereby efficiently encapsulating LEDs. In order to prepare an organic oligosiloxane hybrid having a thermocurable or photocurable functional group, an organic group of organoalkoxysilane or organosilanediol must have the thermocurable or photocurable functional group. Such thermocurable or photocurable functional group may include epoxy, acryl, methacryl, vinyl, amino, hydroxyl group, and the like.

As for the organic oligosiloxane hybrid containing a thermocurable or photocurable functional group, a monomer having the thermocurable or photocurable functional group may be further added thereto. Such monomer may be at least one monomer or a mixture of two or more thereof. Adding monomer may control a density, free volume or refractive index of the organic oligosiloxane hybrid, or adhesiveness thereof to a substrate.

As for the organic oligosiloxane hybrid containing a thermocurable or photocurable functional group, a thermocuring or photocuring catalyst may be further added thereto. Such thermocuring catalyst may include at least one selected from a group consisting of: an amine catalyst such as benzyl dimethylamine; an imidazole catalyst such as 1-methylimidazole, 2-phenylimidazole, etc.; a phosphorus catalyst such as triphenylphosphine, triphenylphosphate, trioctylphosphine, tri-tert-butylphosphine, etc.; and aluminum acetylacetonate (Alacac). Such photocuring catalyst may include arylsulfonium hexafluoroantimonium salt, 2,2-dimethoxy-2-phenyl acetophenone, benzoyl peroxide, dicumyl peroxide, 2,2-azobis-(2-methyl propionitrile), and the like.

Moreover, when the organic oligosiloxane hybrid contains a thermocurable functional group, an acid anhydride curing agent may be added thereto. Such acid anhydride curing agent may include methyl hexahydrophthalic anhydride, methyl tetrahydrophthalic anhydride, nadic methyl anhydride, phthalic anhydride, trimellitic anhydride, maleic anhydride, hexahydrophthalic anhydride, tetrahydrophthalic anhydride, tetrachlorophthalic anhydride, and the like.

If the organic oligosiloxane hybrid containing a thermocurable or photocurable functional group undergoes a thermocuring or photocuring process, the cured hybrid may be further subjected to a heat treatment process. Such heat treatment may be performed at a temperature of not more than 180°C, particularly, in the range of 50 to 180°C. The heat treatment is preferably performed at not more than 150°C, particularly, at 50 to 150°C. If the temperature for heat treatment is higher than 180°C, a bonding chain between organic functional groups may be broken. With the temperature too low, a solvent added to the hybrid difficult to remove.

The resin composition for LED encapsulation of the present invention may further include at least one additive selected from a group consisting of dyes, pigments, surfactants, antioxidants, oxide nanoparticles, nitride nanoparticles, flame retardant agents, metal fillers, and heat resistant agents.

The resin composition for LED encapsulation prepared according to the present invention may be used for LEDs including, for example, recent LEDs with improved luminescence efficiency and a short wavelength, as well as red, green and/or yellow LEDs fabricated using a compound semiconductor GaP, a compound semiconductor GaAs and a compound semiconductor GaN. Such resin composition for LED encapsulation of the present invention may be applied to encapsulation of existing LEDs. However, the inventive resin composition for LED encapsulation is particularly suitable for encapsulating an advanced LED with a high luminescence of more than 80 lm/W in blue light or UV wavelength ranges.

In general, since a resin for LED encapsulation is exposed to high energy and bright light emitted from an LED, the resin requires excellent light resistance. The resin also requires improved heat resistance owing to heat generated near a light emitting area. Such excellent light resistance and heat resistance may assist the LED encapsulation resin to maintain a desired mechanical strength and may prevent a decrease in light transmittance of the resin. Furthermore, as light must pass through the LED encapsulation resin, the resin should have a high light transmittance. Likewise, the LED encapsulation resin must have a high refractive index in order to improve light extraction efficiency thereof. Moreover, in order to protect a light emitting device having a high precision coupling wire, the LED encapsulation resin requires a high hardness.

Consequently, the resin composition for LED encapsulation of the present invention satisfies all of the above requirements, thereby being favorably applied to LED encapsulation resin.

Hereinafter, preferred embodiments of the present invention will be described in detail in the following examples and experimental examples which are given for illustrative purposes only and should not be construed as limiting the spirit and scope of the invention.

## EXAMPLE 1

2-(3,4-epoxycyclohexyl)ethyl trimethoxysilane (ECTMS, available from Aldrich Co.) and diphenylsilanediol (DPSD) were blended in a molar ratio of 2:3 then poured into a 200ml flask. Then, 0.1mol% of a barium hydroxide catalyst relative to silane was added to the mixture and agitated at 80°C for 72 hours. Following this, propyleneglycol methylether acetate (PGMEA, available from Aldrich Co.) was added to the agitated mixture, followed by a reaction thereof at 60°C under a pressure of -0.1MPa using a vacuum evaporator for 30 minutes so as to prepare a resin. A methanol moiety remaining in the resin was removed to obtain an organic oligosiloxane resin having modified epoxy and phenyl groups. After adding a photocuring catalyst, that is, 4 wt.% of arylsulfonium hexafluoroantimonium salt relative to the organic oligosiloxane resin, the resulting material was poured into a plastic mold having 1mm thickness. Next, the material in the mold was exposed to a UV lamp at 365nm for 1 minute to perform photocuring thereof. After completing the photocuring process, the mold was removed and the obtained product was again subjected to thermocuring treatment at 150°C for 2 hours.

## EXAMPLE 2

3-glycidoxypropyl trimethoxysilane (GPTMS, available from Aldrich Co.) and DPSD were blended in a molar ratio of 2:3 then poured into a 200ml flask. Then, 0.1 mol% of a barium hydroxide catalyst relative to silane was added to the mixture and agitated at 80°C for 72 hours. The treated mixture was reacted at 60°C under a pressure of -0.1MPa using a vacuum evaporator for 30 minutes so as to prepare a resin.

A methanol moiety remaining in the resin was removed to obtain an organic oligosiloxane resin having modified epoxy and phenyl groups. 1 mol of methyl hexahydrophthalic anhydride (MHHPA, available from Aldrich Co.) as a thermocuring agent relative to one equivalent weight of the organic oligosiloxane resin was added thereto. Following this, 1 wt.% of benzyl dimethylamine (BDMA, available from Kukdo Co.) as a thermocuring catalyst relative to the organic oligosiloxane resin was added thereto. The resulting material was poured into a polymer coated glass mold having 1mm thickness. After performing the thermocuring process at 120°C for 12 hours, the mold was removed.

## EXAMPLE 3

3-methacrylopropyl trimethoxysilane (MPTMS, available from Aldrich Co.) and DPSD were blended in a molar ratio of 2:3 then poured into a 200ml flask. Then, 0.1mol% of a barium hydroxide catalyst relative to silane was added to the mixture and agitated at 80°C for 72 hours. The treated mixture was reacted at 60°C under a pressure of -0.1MPa using a vacuum evaporator for 30 minutes so as to prepare a resin.

A methanol moiety remaining in the resin was removed to obtain an organic oligosiloxane resin having modified methacryl and phenyl groups. As a monomer having a photocurable functional group, 1,6-hexandiol diacrylate was added to the organic oligosiloxane resin. Following this, 2 wt.% of 2,2-dimethoxy-2-phenyl acetophenone (BDK, available from Aldrich Co.) as a photocuring catalyst relative to the organic oligosiloxane resin was added thereto. The resulting material was poured into a plastic mold having 1mm thickness and was exposed to a UV lamp at 365nm for 4 minutes to perform photocuring thereof. After completing the photocuring process, the mold was removed and the obtained product was again subjected to thermocuring treatment at 120°C for 2 hours.

## EXAMPLE 4

Vinyl trimethoxysilane (VTMS, available from Aldrich Co.) and DPSD were blended in a molar ratio of 2:3 then poured into a 200ml flask. Then, 0.1 mol% of a barium hydroxide catalyst relative to silane was added to the mixture and agitated at 80°C for 72 hours. The treated mixture was reacted at 60°C under a pressure of -0.1MPa using a vacuum evaporator for 30 minutes so as to prepare a resin.

A methanol moiety remaining in the resin was removed to obtain an organic oligosiloxane resin having modified vinyl and phenyl groups. As a monomer having a photocurable functional group, trimethylolpropane triacrylate was added to the organic oligosiloxane resin. Following this, 4 wt.% of benzoyl peroxide (BPO, available from Fluka Co.) as a photocuring catalyst relative to the organic oligosiloxane resin was added thereto. The resulting material was poured into a plastic mold having 1mm thickness and was exposed to a UV lamp at 365nm for 4 minutes to perform photocuring thereof. After completing the photocuring process, the mold was removed and the obtained product was again subjected to thermocuring treatment at 120°C for 2 hours.

## EXAMPLE 5

3-methacrylopropyl trimethoxysilane (MPTMS, available from Aldrich Co.), titanium isopropoxide ($Ti(O^iPr)_4$, available from Aldrich Co.), acetylacetone (available from Aldrich Co.) and DPSD were blended in a molar ratio of 1.2: 0.8:0.8:3 then poured into a 200ml flask. Then, 0.1 mol% of a barium hydroxide catalyst relative to silane was added to the mixture and agitated at 80°C for 72 hours. Next, propyleneglycol methylether acetate (PGMEA, available from Aldrich Co.) was added to the treated mixture, followed by a reaction thereof at 60°C under a pressure of -0.1MPa using a vacuum evaporator for 30 minutes so as to prepare a resin.

A methanol moiety remaining in the resin was removed to obtain an organic oligosiloxane resin having modified methacryl and phenyl groups. Following this, 2 wt.% of 2,2-dimethoxy-2-phenyl acetophenone (BDK, available from Aldrich Co.) as a photocuring catalyst relative to the organic oligosiloxane resin was added thereto. The resulting material was poured into a plastic mold having 1mm thickness.

Then, the material in the mold was exposed to a UV lamp at 365nm for 4 minutes to perform photocuring thereof. After completing the photocuring process, the mold was removed and the obtained product was again subjected to thermocuring treatment at 150°C for 2 hours.

## EXAMPLE 6

3-methacrylopropyl trimethoxysilane (MPTMS, available from Aldrich Co.), zirconium isopropoxide ($Zr(O^iPr)_4$, available from Aldrich Co.), methacrylic acid (available from Aldrich Co.) and DPSD were blended in a molar ratio of 1.2:0.8:0.8:3 then poured into a 200ml flask. Then, 0.1 mol% of a barium hydroxide catalyst relative to silane was added to the mixture and agitated at 80°C for 72 hours. Next, propyleneglycol methylether acetate (PGMEA, available from Aldrich Co.) was added to the treated mixture, followed by a reaction thereof at 60°C under a pressure of -0.1MPa using a vacuum evaporator for 30 minutes so as to prepare a resin.

A methanol moiety remaining in the resin was removed to obtain an organic oligosiloxane resin having modified methacryl and phenyl groups. Following this, 2 wt.% of 2,2-dimethoxy-2-phenyl acetophenone (BDK, available from Aldrich Co.) as a photocuring catalyst relative to the organic oligosiloxane resin was added thereto. The resulting material was poured into a plastic mold having 1mm thickness.

Then, the material in the mold was exposed to a UV lamp at 365nm for 4 minutes to perform photocuring thereof. After completing the photocuring process, the mold was removed and the obtained product was again subjected to thermocuring treatment at 150°C for 2 hours.

## EXPERIMENTAL EXAMPLE

Physical properties of each of samples obtained in the above examples were evaluated by the following procedures and the results are shown in Tables 1 to 3.

[Degree of Condensation]

Using a nuclear magnetic resonance (NMR) spectrometer (available from Bruker Co.), some data were obtained and applied to the following equation so as to calculate a degree of condensation.

$$\text{Degree of Condensation} = \frac{D^1 + 2D^2 + T^1 + 2T^2 + 3T^3}{2(D^0 + D^1 + D^2) + 3(T^0 + T^1 + T^2 + T^3)} \times 100$$

wherein $D^0$, $D^1$, $D^2$, $T^0$, $T^1$, $T^2$ and $T^3$ are represented by the following formula:

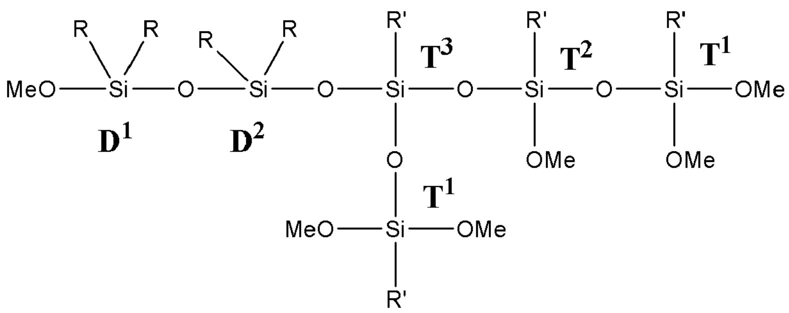

wherein R' is an organic functional group and R is a phenyl group.

[Transmittance]

A transmittance at 450nm was measured using a UV/VIS/NIR spectrum analyzer UV-3101PC available from Shimadzu Corporation.

[Refractive Index]

A refractive index at 633nm was measured using a prism coupler.

[Light Resistance]

After exposing the sample to a lamp at 365nm for 600 hours, a transmittance thereof was measured.

[Heat Resistance]

After placing the sample in an oven at 120°C for 600 hours, a transmittance thereof was measured.

[Hardness]

Using a shore hardness tester HPSD available from Schmidt Co. GmbH, a hardness of the sample was measured and represented by a Shore D value.

Table 1

| Refractive index and Shore D hardness of resin for LED encapsulation | | | | | | |
|---|---|---|---|---|---|---|
| | Ex. 1 | Ex. 2 | Ex. 3 | Ex. 4 | Ex. 5 | Ex. 6 |
| Degree of Condensation (%) | 97 | 90 | 84 | 91 | 93 | 90 |
| Refractive Index | 1.56 | 1.56 | 1.55 | 1.54 | 1.59 | 1.59 |
| Hardness (Shore D) | 61 | 68 | 63 | 62 | 56 | 58 |

Table 2

| Transmittances before and after UV irradiation of resin for LED encapsulation | | | | | | |
|---|---|---|---|---|---|---|
| | Ex. 1 | Ex. 2 | Ex. 3 | Ex. 4 | Ex. 5 | Ex. 6 |
| Initial | 96 | 92 | 95 | 96 | 89 | 91 |
| After 600 hours | 92 | 91 | 92 | 91 | 86 | 87 |

Table 3

| Transmittances before and after heat treatment of resin for LED encapsulation | | | | | | |
|---|---|---|---|---|---|---|
| | Ex. 1 | Ex. 2 | Ex. 3 | Ex. 4 | Ex. 5 | Ex. 6 |
| Initial | 96 | 92 | 95 | 96 | 89 | 91 |
| After 600 hours | 93 | 90 | 91 | 92 | 85 | 86 |

Table 1 shows refractive indexes and hardnesses of the resins for LED encapsulation produced according to Examples 1 to 6. Table 2 shows transmittances before and after UV irradiation of each of the resins for LED encapsulation produced in Examples 1 to 6. Also, Table 3 shows transmittances before and after heat treatments at 120°C for 600 hours of each of the resins for LED encapsulation produced in Examples 1 and 6.

The resins for LED encapsulation produced in Examples 5 and 6 were prepared by adding metal alkoxide to the oligosiloxane resin obtained in Example 3. It can be seen that both the resins for LED encapsulation produced in Examples 5 and 6 exhibited considerably improved degree of condensation and refractive indexes, compared to the resin for LED encapsulation produced according to Example 3.

From the results shown in Tables 1 to 3, it can be understood that the resin for LED encapsulation of the present invention has high transmittance and refractive index as well as excellent light resistance and heat resistance. Moreover, the inventive resin for LED encapsulation has a desired hardness preferable to use as a substance for LED encapsulation with high luminescence efficiency and a short wavelength.

While the present invention has been described with reference to preferred embodiments, it will be understood by those skilled in the art that various modifications and variations may be made therein without departing from the scope of the present invention as defined by the appended claims.

## Claims

**1.** A resin composition for LED encapsulation, comprising an organic oligosiloxane hybrid prepared by non-hydrolytic condensation of organoalkoxysilane with organosilanediol or non-hydrolytic condensation of a mixture containing organoalkoxysilane and metal alkoxide with organosilanediol.

**2.** The resin composition according to claim 1, wherein the metal alkoxide is contained in an amount of 1 to 80 mol% relative to 100 mol% of the mixture.

**3.** The resin composition according to claim 1, wherein the organoalkoxysilane is at least one selected from compounds represented by Formula 1 or a mixture of two or more thereof:

Formula 1

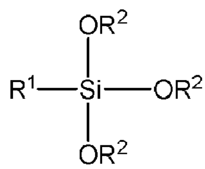

wherein $R^1$ is at least one selected from a group consisting of $C_1$ to $C_{20}$ alkyl, $C_3$ to $C_8$ cycloalkyl, $C_1$ to $C_{20}$ alkyl substituted by $C_3$ to $C_8$ cycloalkyl, $C_2$ to $C_{20}$ alkenyl, $C_2$ to $C_{20}$ alkynyl and $C_6$ to $C_{20}$ aryl and each of which may have at least one functional group selected from a group consisting of acryl, methacryl, allyl, halogen, amino, mercapto, ether, ester, $C_1$ to $C_{20}$ alkoxy, sulfone, nitro, hydroxyl, cyclobutene, carbonyl, carboxyl, alkyd, urethane, vinyl, nitrile and epoxy groups; and $R^2$ is a linear or branched $C_1$ to $C_7$ alkyl group.

**4.** The resin composition according to claim 1, wherein the organosilanediol is at least one selected from compounds represented by Formula 2 or a mixture of two or more thereof:

Formula 2

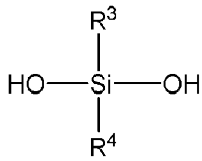

wherein $R^3$ and $R^4$ are independently at least one selected from a group consisting of $C_1$ to $C_{20}$ alkyl, $C_3$ to $C_8$ cycloalkyl, $C_1$ to $C_{20}$ alkyl substituted by $C_3$ to $C_8$ cycloalkyl, $C_2$ to $C_{20}$ alkenyl, $C_2$ to $C_{20}$ alkynyl and $C_6$ to $C_{20}$ aryl and each of which may have at least one functional group selected from a group consisting of acryl, methacryl, allyl, halogen, amino, mercapto, ether, ester, $C_1$ to $C_{20}$ alkoxy, sulfone, nitro, hydroxyl, cyclobutene, carbonyl, carboxyl, alkyd, urethane, vinyl, nitrile and epoxy groups.

**5.** The resin composition according to claim 1, wherein the metal alkoxide is at least one selected from compounds represented by Formula 3 or a mixture of two or more thereof:

Formula 3 $M\text{-}(OR^5)_n$

wherein M is at least one selected from a group consisting of aluminum, germanium, titanium, zirconium and tantalum; n is atomic valence of M; and $R^5$ is a linear or branched $C_1$ to $C_7$ alkyl group.

**6.** The resin composition according to claim 1, wherein the organoalkoxysilane is at least one selected from a group consisting of 3-glycidoxypropyl trimethoxysilane, 3-glycidoxypropyl triethoxysilane, 2-(3,4-epoxycyclohexyl)ethyl trimethoxysilane, 2-(3,4-epoxycyclohexyl)ethyl triethoxylsilane, methyltrimethoxysilane, methyltriethoxysilane, methyltripropoxysilane, propylethyltrimethoxysilane, ethyltriethoxysilane, vinyltrimethoxysilane, vinyltriethoxysilane, vinyltripropoxysilane, phenyltrimethoxysilane, N-(3-acryloxy-2-hydroxypropyl)-3-aminopropyl triethoxysilane, N-(3-acryloxy-2-hydroxypropyl)-3-aminopropyl trimethoxysilane, N-(3-acryloxy-2-hydroxypropyl)-3-aminopropyl tripropoxysilane, 3-acryloxypropyl methylbis(trimethoxy)silane, 3-acryloxypropyl trimethoxysilane, 3-acryloxypropyl triethoxysilane, 3-acryloxypropyl tripropoxysilane, 3-(meth)acryloxypropyl trimethoxysilane, 3-(meth)acryloxypropyl triethoxysilane, 3-(meth)acryloxypropyl tripropoxysilane, N-(aminoethyl-3-aminopropyl)trimethoxysilane, N-(2-aminoethyl-3-aminopropyl)triethoxysilane, 3-aminopropyl trimethoxysilane, 3-aminopropyl triethoxysilane, chloropropyl trimethoxysilane, chloropropyl triethoxysilane and heptadecafluorodecyl trimethoxysilane or a mixture of two or more thereof.

**7.** The resin composition according to claim 1, wherein the organosilanediol is at least one selected from a group consisting of diphenylsilanediol and diisobutylsilanediol or a mixture of two or more thereof.

**8.** The resin composition according to claim 1, wherein the metal alkoxide is at least one selected from a group consisting of aluminum ethoxide, tantalum ethoxide, germanium ethoxide, titanium ethoxide, zirconium ethoxide, zirconium propoxide, titanium propoxide, aluminum isopropoxide, germanium isopropoxide, titanium isopropoxide, zirconium isopropoxide, aluminum tributoxide, tantalum butoxide, aluminum t-butoxide, titanium butoxide, titanium t-butoxide, zirconium butoxide and zirconium t-butoxide or a mixture of two or more thereof.

**9.** The resin composition according to claim 1, wherein the mixture further contains a metal chelating agent.

**10.** The resin composition according to claim 9, wherein a content of the metal chelating agent ranges from 1/5 to 1/2 equivalent weight to alkoxide portion of the metal alkoxide.

**11.** The resin composition according to claim 9, wherein the metal chelating agent is a β-diketonate compound or an organic acid having an unsaturated hydrocarbon group.

**12.** The resin composition according to claim 1, wherein the non-hydrolytic condensation is performed in the presence of a metal hydroxide catalyst.

**13.** The resin composition according to claim 1, wherein the organic oligosiloxane hybrid has a thermocurable or photocurable functional group.

**14.** The resin composition according to claim 13, wherein a thermocuring or photocuring catalyst is added to the organic oligosiloxane hybrid.

**15.** The resin composition according to claim 13, wherein an acid anhydride catalyst is added to the organic oligosiloxane hybrid.

**16.** The resin composition according to claim 13, wherein the organic oligosiloxane hybrid further contains a monomer having a thermocurable or photocurable functional group.

**17.** The resin composition according to claim 1, further comprising at least one additive selected from a group consisting of: solvents, dyes, pigments, surfactants, antioxidants, oxide nanoparticles, nitride nanoparticles, flame retardant agents, metal fillers and heat resistant agents.

**18.** An encapsulated LED fabricated using the resin composition for LED encapsulation as set forth in any one of claims 1 to 17.

Europäisches Patentamt
European Patent Office
Office européen des brevets

# EUROPEAN SEARCH REPORT

Application Number
EP 09 15 8633

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/244658 A1 (BAE BYEONG-SOO [KR] ET AL) 3 November 2005 (2005-11-03)<br>* page 5, paragraph [0059]; claims 1,3; examples 1,2 * | 1-18 | INV.<br>H01L33/52<br>H01L23/29<br>C08G77/04<br>C08G77/06<br>C08G77/58<br>C08G79/00<br>C08G79/10 |
| X | US 6 984 483 B1 (ROSCHER CHRISTOF [DE] ET AL) 10 January 2006 (2006-01-10)<br>* column 13, line 13; claim 1 * | 1-18 | |
| X | US 2006/081864 A1 (NAKAZAWA KEIICHI [JP]) 20 April 2006 (2006-04-20)<br>* & JP 2004 359756 (D); page 5, paragraph [0056]; claim 1 * | 1 | |

TECHNICAL FIELDS SEARCHED (IPC)
H01L
C08G

The present search report has been drawn up for all claims

1

| Place of search | Date of completion of the search | Examiner |
|---|---|---|
| The Hague | 26 November 2009 | Lentz, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 15 8633

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2009

| Patent document cited in search report | Publication date | Patent family member(s) | Publication date |
|---|---|---|---|
| US 2005244658 A1 | 03-11-2005 | JP 4164486 B2 | 15-10-2008 |
| | | JP 2005298800 A | 27-10-2005 |
| | | KR 20050099849 A | 17-10-2005 |
| US 6984483 B1 | 10-01-2006 | AT 247144 T | 15-08-2003 |
| | | CA 2378756 A1 | 18-01-2001 |
| | | WO 0104186 A1 | 18-01-2001 |
| | | DE 19932629 A1 | 18-01-2001 |
| | | EP 1196478 A1 | 17-04-2002 |
| US 2006081864 A1 | 20-04-2006 | CN 1798810 A | 05-07-2006 |
| | | EP 1651724 A2 | 03-05-2006 |
| | | WO 2004107458 A2 | 09-12-2004 |
| | | JP 2004359756 A | 24-12-2004 |
| | | KR 20060016107 A | 21-02-2006 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020080074862
- JP 2003002951 A
- KR 1020080043381
- JP 2004359756 A
- JP 2004186168 A